# EUROPEAN PATENT APPLICATION

(11) **EP 1 500 810 A1**
(43) Date of publication of application: **26.01.2005**
(21) Application number: 04002002.6
(22) Date of filing: 29.01.2004
(51) Int. Cl.: F02M 51/06, F02M 59/46, F02M 61/16

(54) **Actuator unit**

(71) Applicant: Siemens VDO Automotive S.p.A., 56040 Fauglia (Pisa) (IT)
(72) Inventor: Biagetti, Fabrizio, 57128 Livorno (IT)
(74) Representative: Berg, Peter, Dipl.-Ing.

(57) **Abstract**

An actuator unit comprises a tube spring (32), a piezoelectric actuator (31) that is inserted into the tube spring (32), a first cap (33), that is connected to the tube spring (32) at a first free end (34) of the tube spring (32) and that is adjoined by the piezoelectric actuator (31), and a second cap (36), that is connected to the tube spring (32) at a second free end (35) of the tube spring (32) and that is adjoined by the piezoelectric actuator (31). The first and/or the second cap (33, 36) has a recess (3331, 361) into which a ball (332, 362) is inserted, that projects outwards from the first and/or the second cap (33, 36) on the side that is facing away from the piezoelectric actuator (31) and forms a contact for an element.

## Description

The invention relates to an actuator unit with a tube spring and a piezoelectric actuator, that is inserted into the tube spring and is pretensioned by the tube spring.

Actuator units with a piezoelectric actuator are in widespread use and are increasingly used for fuel injectors for internal combustion engines. They have the advantage of having a very fast response time to actuating signals and therefore enable multiple injections into a cylinder of the internal combustion engine during one working cycle of the cylinder.

WO 00/08353 discloses an actuator unit with a tube spring, a piezoelectric actuator that is inserted into the tube spring, a first cap that is connected to the tube spring at a first free end of the tube spring and which is adjoined by the piezoelectric actuator, and a second cap that is connected to the tube spring at a second free end of the tube spring and which is also adjoined by the piezoelectric actuator. The first and second caps are welded to the tube spring. The tube spring is preferably made out of steel and has recesses that are formed in a bone-shaped manner. The piezoelectric actuator is pretensioned by the tube spring. The pretension forces are transmitted to the piezoelectric actuator by the first and second cap. When a voltage is applied to the actuator unit, the actuator unit changes its axial length. If it is used, for example, for a fuel injector it is inserted into a housing of the fuel injector and is contacted on one of its caps by a first element and is contacted on the second cap by a second element, which is for example a needle of the injection valve. If a voltage is applied to the actuator unit it lengthens and in that way acts on the second element and moves it respectively. In order to ensure a precise operation the surface of the first and second caps, which contact the first or respectively the second element need to be precisely rectangular to enable a good guide of the actuator unit. In addition to that also the respective surfaces of the first and the second element need to be manufactured precisely in order to ensure a good contact between the caps and the first or respectively the second element and to enable a good guide of the actuator unit. Up to now this is achieved by a special flat grinding operation.

The object of the invention is to create an actuator unit, which is simple and at the same time has a high quality.

This object is achieved by the features of the independent claim. Advantageous embodiments of the invention are given in the subclaims.

The invention is distinguished by an actuator unit with a tube spring, a piezoelectric actuator, that is inserted into the tube spring, a first cap, that is connected to the tube spring at a first free end of the tube spring and that is adjoined by the piezoelectric actuator, and a second cap, that is connected to the tube spring at a second free end of the tube spring and that is adjoined by the piezoelectric actuator. The first and/or the second cap have a recess, into which a ball is inserted, that projects outwards from the first and/or the second cap on the side that is facing away from the piezoelectric actuator and forms a contact for an element. Such balls are widely and fairly cheaply available and are precisely formed. A high quality contact to the element is ensured because of the spherical shape of the ball.

In an advantageous embodiment of the actuator unit the ball is interference fitted in the recess of the first or respectively the second cap. That way a simple, defined and tight fit is ensured.

In a further advantageous embodiment of the actuator unit the ball is made out of steel with a high share of carbon. Such a steel is very hard and in that way the ball is very wear-resistant.

In a further advantageous embodiment of the actuator unit the first and/or the second cap are made out of steel with a small share of carbon. Steel with a small share of carbon is well-suited for welding, especially for laser-welding.

Exemplary embodiments of the invention are explained in the following with the aid of schematic drawings. These are as follows:
- Figure 1: a fuel injector with an actuator unit and
- Figure 2: the actuator unit.

Elements of the same design and function that occur in different illustrations are identified by the same reference character.

A fluid injector, that is embodied as a fuel injector, that is suitable for injecting fuel into a gasoline engine or that may also be suitable for injecting fuel into a diesel engine, comprises a housing 1, a valve body 2 and an actuator unit 3. The fuel injector is preferably located in a cylinder head of an internal combustion engine and provides a combustion chamber with fuel. The housing may be double tube-shaped. In the space between the walls of the double tube the fuel may be led to the valve body 2.

The valve body 2 comprises a cartridge 21 with a recess and a needle 22 that is inserted into the recess and is guided in the area of a guide 23. The needle 22 is of an outward opening type, but it may also be of an inward opening type. The needle 22 is pushed in its closed position by a return spring 24, which rests on a spring washer 25, that is connected to the needle 22. The return spring 24 exerts a force on the needle 22 in the closing direction of the needle 22.

The actuator unit 3 is inserted into an inner tube 11 of the housing 1. The actuator unit is contacted on one of its axial ends by a first element that is embodied as a thermal compensator 4 and on its other axial end contacts a second element that is embodied as the needle 22. Depending on actuating signals the actuator unit 3 changes its axial length and in that way pushes the needle 22 in its open position or leaves it in its closed position.

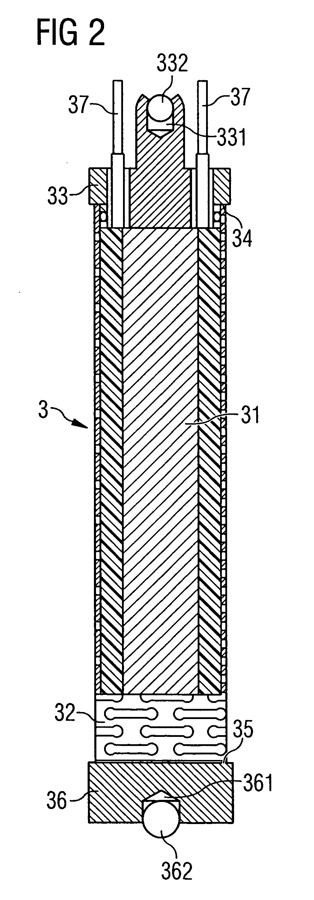

The actuator unit 3 (Figure 2) comprises a piezo actuator 31, that is inserted into a tube spring 32 which pretensions the piezo actuator with a given force. The tube spring 32 is preferably made out of steel and comprises various recesses, that are formed in a bone-shaped manner. The tube spring needs to made of a material and to be formed in a way that it can uphold the pretension and is also flexible enough for the further axial lengthening of the piezo actuator 31. The actuator unit 3 further comprises a first cap 33, that is joined to the tube spring 32 at a first free end 34 of the tube spring 32. The first cap 33 has holes in which contact pins 37 are inserted and are electrically contacted to electrodes of the piezo elements of the piezo actuator 31. The piezo actuator 31 comprises a stack of piezo elements. The first cap 33 is preferably welded to the tube spring 32 at the first free end 34. It is preferably laser-welded. Preferably the first cap 33 is made out of steel with a small share of carbon as this makes it most suitable for welding, especially laser-welding.

The first cap 33 comprises a recess 331, that is preferably formed as a blind hole, which is open on a side of the first cap 33, which faces away from the piezo actuator 31. A ball 332 is inserted in the recess 331 and projects outwards from the first cap 33 on the side that is facing away from the piezoelectric actuator 31 and forms a contact for an element, that in this embodiment is the thermal compensator 4. The ball is fitted into the recess 331 and can transmit the force to the first cap 33. The ball is preferably fitted into the first recess 331 by an interference fit. An interference fit may best be achieved by heating up the first cap to, for example, 300°C and inserting the ball 332, which is not heated. After the ball 332 is inserted the first cap 33 is cooled down again and in that way the recess shrinks and the interference fit is established.

The ball 332 is preferably made out of steel with a high share of carbon. Such a steel has the property of being very hard and in that way the ball 332 is then very wear-resistant. Because of the spherical shape of the ball, which contacts the thermal compensator 4, a precise contact and movement can be achieved, even if the first cap 33 and thermal compensator are not fully aligned. In addition to that the material of the first cap 33 can be chosen to be most suited for a welding, especially for a laser-welding process, and the material of the ball 332 may be chosen to ensure a high level of wear resistance. In that way an expensive hardening treatment of an otherwise existing contacting area of the first cap does not need to be made. Such a hardening treatment may be a hard chrome flash or an induction temper, which makes the actuator unit 3 more expensive. Alternatively a fitting of the ball 332 in the recess 331 may be achieved by a crimping process or another process known to a person skilled in the art.

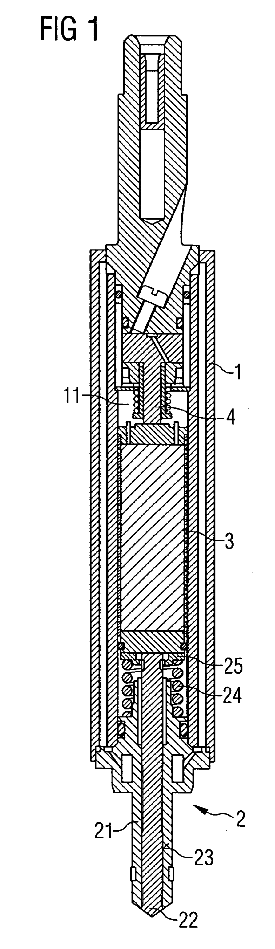

The actuator unit 3 further comprises a second cap 36, that is joined to the tube spring 32 at a second free end 35 of the tube spring 32. The second cap 36 also has a recess 361, that is preferably formed as a blind hole and into which a ball 362 is inserted. The recess 361 and the ball 362 of the second cap 36 may be respectively formed as the ball 332 and the recess 331 of the first cap. The ball 362 is fitted into the recess 361 of the second cap 36 and contacts a second element, which in the embodiment of Figure 1 is the needle 22 of the fuel injector. The material of the ball 362 and the second cap 36 may be identical to the material of the ball 332 and respectively of the first cap 33. The points mentioned above concerning the first cap 33, its recess 331 and its ball 332 may be respectively applied to the second cap 36, its recess 361 and its ball 362. Alternatively only one of the caps 33, 36 may comprise a recess 361, 331 and a ball 362, 332.

## Claims

1. Actuator unit with
- a tube spring (32),
- a piezoelectric actuator (31), that is inserted into the tube spring (32),
- a first cap (33), that is connected to the tube spring (32) at a first free end (34) of the tube spring (32) and which is adjoined by the piezoelectric actuator (31),
- a second cap (36), that is connected to the tube spring (32) at a second free end (35) of the tube spring (32) and which is adjoined by the piezoelectric actuator (31), and with the first and/or the second cap (33, 36) having a recess (331, 361), into which a ball (332, 362) is inserted, that projects outwards from the first and/or the second cap (33, 36) on the side, that is facing away from the piezoelectric actuator (31) and forms a contact for an element.

2. Actuator unit in accordance with claim 1 with the ball (332, 362) being interference fitted in the recess (331, 361) of the first or respectively the second cap (33, 36).

3. Actuator unit in accordance with one of the preceding claims with the ball (332, 362) being made out of steel with a high share of carbon.

4. Actuator unit in accordance with one of the preceding claims with the first and/or the second cap (33, 36) being made out of steel with a small share of carbon.
